Europäisches Patentamt

European Patent Office

Office européen des brevets

(19)

(11) Numéro de publication: **0 193 462 B1**

(12) **FASCICULE DE BREVET EUROPEEN**

(45) Date de publication du fascicule du brevet:
29.03.89

(51) Int. Cl.⁴: **H01L 29/90**

(21) Numéro de dépôt: 86400379.3

(22) Date de dépôt: 21.02.86

(54) Diode hyperfréquence de type PIN à transitions abruptes.

(30) Priorité: 26.02.85 FR 8502766

(43) Date de publication de la demande:
03.09.86 Bulletin 86/36

(45) Mention de la délivrance du brevet:
29.03.89 Bulletin 89/13

(84) Etats contractants désignés:
DE GB NL

(56) Documents cités:
EP-A- 0 077 004
EP-A- 0 135 733

JOURNAL OF APPLIED PHYSICS,
vol. 39, no. 7, June 1968, pages 3244-3250, New York,
US; J.E. NORDMAN et al.: "Negative-resistance
current-voltage characteristics of an indium antimonide
p+-p-n+ diode"
PATENTS ABSTRACTS OF JAPAN, vol. 5, no. 103 (E-64)
[775], 3 juillet 1981, page 60 E 64; & JP - A - 56 45 081

(73) Titulaire: THOMSON-CSF, 173, Boulevard Haussmann,
F-75379 Paris Cédex 08(FR)

(72) Inventeur: Henry, Raymond, THOMSON-CSF
SCPI 19, Avenue de Messine, F-75008 Paris(FR)
Inventeur: Berger, Didier, THOMSON-CSF
SCPI 19, Avenue de Messine, F-75008 Paris(FR)
Inventeur: Straehli, Christian, THOMSON-CSF
SCPI 19, Avenue de Messine, F-75008 Paris(FR)

(74) Mandataire: Taboureau, James et al, THOMSON-CSF
SCPI 19, avenue de Messine, F-75008 Paris(FR)

## Description

La présente invention concerne le domaine des semiconducteurs, et plus précisément une diode hyperfréquence de type PIN, sur silicium, à faible résistance série, réalisée par épitaxie de couches peu dopées, de types de conductivité P et N, sur un substrat intrinsèque ou de haute résistivité.

Les diodes PIN sont bien connues et elles sont normalement obtenues par diffusions dans un substrat de haute résistivité: une diffusion de type P sur une face de la tranche de substrat, et une diffusion de type N sur l'autre face de cette tranche. L'inconvénient est que, comme conséquence du procédé de diffusion, le taux de dopage des couches P et N est très élevé en surface de la tranche et très faible à l'interface entre couche dopée et substrat non dopé. Il y a donc deux transitions, P–I et I–N, qui ne sont pas abruptes: ceci oblige à appliquer une tension inverse de polarisation élevée pour réduire les pertes dans les couches P et N, mais il est alors nécessaire d'augmenter l'épaisseur du substrat I pour que la diode ne soit pas détruite par claquage lorsqu'à la tension inverse de polarisation est ajoutée la tension du signal hyperfréquence. Or l'augmentation de l'épaisseur du substrat I entraine l'augmentation de la résistance en sens direct de la diode.

L'invention propose une diode PIN, dont les transitions P–I et I–N, entre couches P et intrinsèque d'une part et entre couches intrinsèque et N d'autre part, sont abruptes, et dont le substrat, c'est-à-dire la couche intrinsèque a une résistivité élevée, ce qui équivaut à une faible résistance série en direct. Les transitions abruptes sont obtenues au moyen de deux couches P et N – une sur chaque face du substrat – qui sont épitaxiées, au lieu d'être diffusées selon l'art antérieur. De plus, ces deux couches sont de 10 à 100 fois moins dopées que les couches diffusées ou épitaxiées de l'art antérieur: leur niveau de dopage est de l'ordre de $10^{17}$ environ à $10^{18}$, comparé à un niveau de dopage de l'ordre de $10^{19}$ à $10^{20}$ dans les diodes diffusées ou épitaxiées suivant l'art connu. Le niveau de dopage étant constant dans toute l'épaisseur des couches épitaxiées – sauf en deux caissons surdopés pour métallisation à faible résistance de contact – les jonctions sont abruptes.

De façon plus précise, l'invention concerne une diode hyperfréquence de type PIN selon la revendication 1.

L'invention sera mieux comprise par la description qui suit d'un exemple de réalisation de diode PIN et des explications de son fonctionnement, ainsi que de son procédé de fabrication, cette description s'appuyant sur les figures jointes en annexes, qui représentent:

– figure 1: vue en coupe d'une diode PIN selon l'art connu, superposée au profil de dopage de cette diode,
– figure 2: schéma équivalent d'une diode PIN soumise à une tension inverse de polarisation supérieure à la tension de perçage,
– figure 3: courbe des capacités et résistances d'une diode PIN, en fonction de la tension,
– figure 4: schéma équivalent d'une diode PIN soumise à une tension inverse de polarisation inférieure à la tension de perçage,
– figure 5: vue en coupe d'une diode PIN selon l'invention superposée à son profil de dopage.

La simplicité de l'invention, et les caractéristiques de la diode PIN qui en résulte, seront mieux comprises par un exposé préalable des conditions de fonctionnement d'une diode PIN, et par comparaison avec une diode PIN selon l'art antérieur.

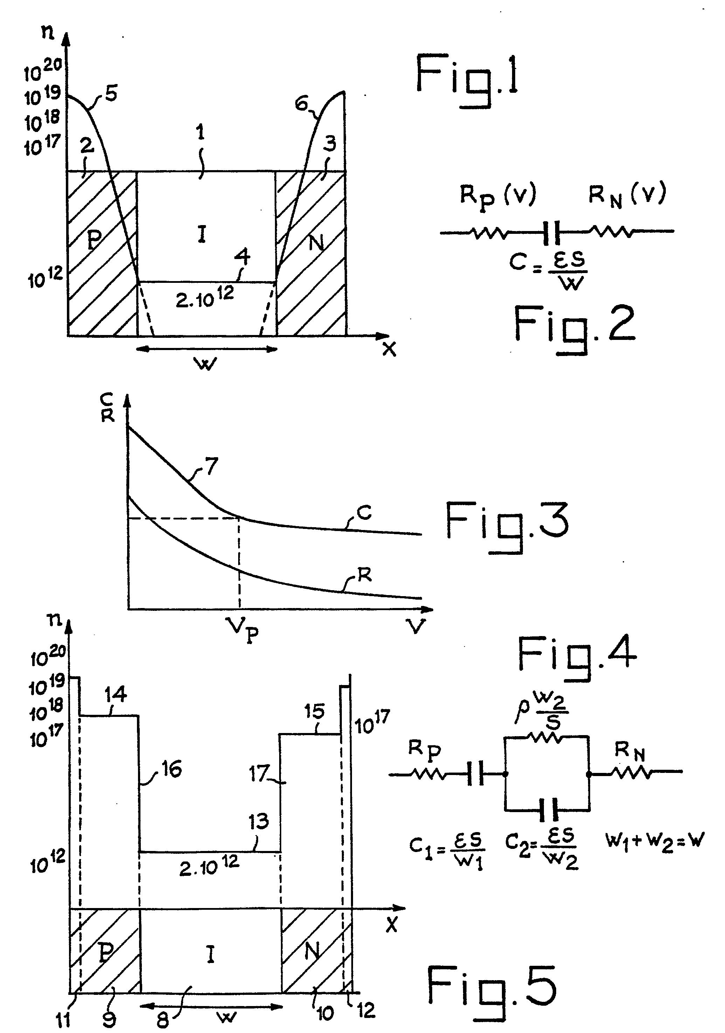

La figure 1 représente une vue en coupe d'une diode PIN selon l'art connu. De structure très simple, elle est obtenue à partir d'une tranche de matériau – généralement du silicium – de haute résistivité ρ, environ 4000 Ω/cm, de type P non compensé que l'on dénomme I (intrinsèque) ou π, c'est-à-dire P involontairement dopé: le niveau de dopage est en effet très faible, de l'ordre de $2.10^{12}$ at.cm$^{-3}$. C'est le matériau de cette tranche qui fournit la couche I repérée 1.

Par deux diffusions successives, et en prenant bien entendu les mesures de masquages appropriées, on diffuse des impuretés de type P, par exemple du bore, sur une face de la tranche pour créer une couche P repérée 2, puis des impuretés de type N, par exemple du phosphore, sur l'autre face de la tranche, pour créer une couche N repérée 3. Les deux diffusions sont en général menées à la même profondeur, de l'ordre de 20 μm par exemple.

Deux métallisations – non représentées – déposées sur les faces externes des couches 2 et 3 assurent un contact ohmique de prise de contact de très faible résistance. Elles sont réalisées selon un procédé connu tel que Ni–Au ou par la "chaine" SiPt–Ti–Pt–Au.

Sur cette vue en coupe d'une diode PIN selon l'art connu a été superposé le profil de dopage des couches, dont le niveau "n" est porté en ordonnées. Les opérations de diffusion apportent un taux de dopage – P ou N selon la couche considérée – qui est de l'ordre de $10^{19}$ à $10^{20}$ en surface, c'est-à-dire sur les faces externes des couches 2 et 3. Or, c'est une conséquence de la diffusion que ces niveaux de dopage ne sont pas constants dans toute l'épaisseur de la couche diffusée, puisqu'il y a un front de dopage qui s'appauvrit au fur et à mesure qu'il pénètre dans la tranche initialement non dopée. Il en résulte que, si le substrat ou couche intrinsèque 1 est à l'origine, par exemple, au niveau $2.10^{12}$, le niveau de dopage dans l'épaisseur des couches 2 et 3 évolue, par exemple, de $10^{20}$ ou $10^{19}$ à environ $2.10^{12}$ à la jonction P–I et à la jonction I–N: c'est ce qui est représenté par la courbe 5 pour la couche 2, et par la courbe 6 pour la couche 3.

On dit alors que les transitions P–I et I–N ne sont pas abruptes mais graduelles, et cela intervient sur les résistances des couches 2 et 3, qui varient avec la tension à laquelle elles sont soumises.

C'est donc un objet de la présente invention que de réaliser une diode PIN à transitions abruptes.

Il faut considérer trois domaines de tension pour une diode PIN.

Dans le premier cas, la tension inverse de polarisation $-V$ est supérieure à la tension de perçage $-V_p$.

$$-V > -V_p$$

$V_p$ étant la tension pour laquelle la zone I de la diode est en charge d'espace, c'est-à-dire ne contient plus de porteurs de charges libres (électrons et trous), mais uniquement des charges fixes qui sont dues aux atomes d'impuretés ionisées (négativement pour le type $P^-$ ou $\pi$).

La tension de perçage est donnée en première approximation par l'expression:

$$V_p \simeq 1,1.10^{-3}.W^2.\frac{\rho_o}{\rho\,\text{réel}}$$

avec $V_p$ en volts

$W$ = épaisseur de la zone I, en microns

$\rho_o$ = résistivité du matériau de départ, par exemple $4000\,\Omega/c\,m$ dans l'exemple cité et pour la formule employée,

$\rho_{\text{réel}}$: résistivité réelle de la zone I de la diode PIN réalisée.

Comme on cherche une tension de perçage $V_p$ la plus faible possible, pour avoir une capacité la plus faible possible de la zone I, il est nécessaire de réaliser la diode selon un processus qui conserve à $\rho$ sa valeur initale ($\rho_{\text{réel}} = \rho_o$) ou, mieux, qui l'augmente.

En charge d'espace, le schéma équivalent d'une diode PIN est donné par la figure 2, dans laquelle:

– $R_P$ (V) représente la résistance de la couche P pour un potentiel V

– $R_N$ (V) représente la résistance de la couche N pour un potentiel V,

– C représente la capacité de la zone I. C'est bien une capacité puisqu'elle est, dans ce cas, dépourvue d'électrons et de trous, et sa valeur est, comme cela est connu, donnée par l'expression

$$C = \frac{\varepsilon S}{W}$$

avec $\varepsilon$ = constante diélectrique du matériau I

$S$ = section offerte au passage du courant par la diode PIN

$W$ = longueur, ou épaisseur de la zone I.

Mais, comme le montre la figure 3 qui donne les courbes de capacité et de résistance d'une diode PIN en fonction de la tension inverse, les résistances $R_P$ et $R_N$ diminuent lorsque la tension V augmente. Simultanément, la capacité décroît dans une fraction 7 de la courbe, qui correspond aux basses fréquences, jusqu'à la valeur de la tension de perçage $V_p$, puis diminue beaucoup plus lentement avec la tension et cela d'autant plus lentement que les transitions sont moins graduelles.

Plus les diffusions des couches 2 et 3 d'une diode PIN sont profondes, plus les résistances $R_P$ et $R_N$ sont élevées, pour une tension donnée, car la résistance des transitions P–I et I–N dans la partie qui n'est pas en charge d'espace peut être importante. Si la diode est placée en shunt dans une ligne de transmission, elle amène une perte proportionnelle à $(R_P + R_N)C^2$ de sorte que des transitions pas assez abruptes obligent à appliquer une tension de polarisation élevée afin de réduire les pertes, en réduisant $R_P$, $R_N$ et C.

Mais ceci est un inconvénient, car la tension de claquage $V_C$ d'une diode doit toujours être supérieure à la somme de la tension inverse de polarisation et de la tension de crête du signal hyperfréquence. Or, la tension de claquage $V_C$ est liée à l'épaisseur $W$ de la zone I par l'expression approximative:

$V_C = (10 \text{ à } 15)W_{\text{micromètres}}$

Si on augmente $W$ pour augmenter $V_C$, on augmente simultanément la tension de perçage $V_P$, mais surtout la résistance de la diode en sens direct, ce qui est un inconvénient majeur.

Le second cas de domaine de fonctionnement d'une diode PIN est celui où la tension inverse est inférieure à la tension de perçage $-V_p$.

Le schéma équivalent de la diode est alors donné par la figure 4.

Les résistances $R_P$ et $R_N$ des couches P et N, 2 et 3 respectivement, sont à leurs valeurs maximales ou en sont proches, puisque, selon la figure 3, la résistance augmente lorsque la tension diminue.

La zone I est constituée par une première zone en charge d'espace équivalente à une capacité $C_1 = \varepsilon S/W_1$, dont $W_1$ est la longueur de cette zone, et par une deuxième zone qui n'est pas en charge d'espace, équivalente à une capacité $C_2 = \varepsilon S/W_2$, shuntée par une résistance de valeur $\rho W_2/S$. Bien entendu, la somme des longueurs $W_1$ et $W_2$ des deux zones est égale à la longueur $W$ de la zone I.

La perte introduite en tension inverse est d'autant plus faible que $\rho$ est élevé dans $\rho W_2/S$.

Le troisième cas concerne la tension directe, entraînant le passage d'un courant direct $I_D$. La zone I est alors entièrement remplie de porteurs de charge injectés, trous et électrons en quantité égale, représentant une charge $Q_D$ pour chacun des types de porteurs. Elle est équivalente en première approximation à une résistance $R_D$ telle que:

$$R_D = \frac{1}{q(\mu_n + \mu_p)n} \cdot \frac{W}{S}$$

pour laquelle:

– $q$ = charge de l'électron = $1,6.10^{-19}C$

– $\mu_n$ et $\mu_p$ = mobilités des charges N et P respectivement,

– $n$ = nombre de charges

– $W$ = longueur de la zone I, ou encore épaisseur de la couche I

– $S$ = section offerte par la diode au passage du courant

Etant donné que:

$Q_D = qnWS$

on en tire:

$$R_D = \frac{W^2}{(\mu_n + \mu_p)Q_D} = \frac{W^2}{(\mu_n + \mu_p)I_D \tau}$$

$\tau$ étant par définition la durée de vie apparente des porteurs de charges injectés.

Il y a donc intérêt, pour que la résistance en direct $R_D$ soit minimale, à ce que $\tau$ soit maximal. Or, on sait que la durée de vie $\tau$ est influencée négativement par les contraintes mécaniques entre zones très dopées P et N et la zone I peu dopée.

Il importe donc de rechercher:

- des transitions P–I et I–N abruptes, afin d'optimiser le fonctionnement de la diode dans le cas où la tension inverse est supérieure à la tension de perçage,
- une résistivité finale $\rho_{réel}$ la plus élevée possible, afin de réduire les pertes dans le cas où la tension inverse est inférieure à la tension de perçage,
- une durée de vie $\tau$ la plus élevée possible, afin de réduire la résistance en direct $R_D$.

Ces objectifs sont atteints avec la diode PIN selon l'invention, qui est représentée en figure 5, sur laquelle la structure de la diode est rapportée en dessous de l'axe des abscisses, tandis que les niveaux de dopage sont rapportés au-dessus de ce même axe, afin de ne pas confondre les jonctions entre couches et les niveaux de transitions abruptes, qui se superposeraient.

La diode PIN selon l'invention est réalisée – de façon collective bien entendu – à partir d'une tranche de silicium parfaitement rodée et donc d'épaisseur bien controlée, qui correspond à la zone I repérée 8. Cette tranche n'est pas intentionnellement dopée, c'est-à-dire que son niveau d'impuretés se situe aux environs de $10^{12}$.

Sur ce substrat sont réalisées deux couches épitaxiées, une couche P 9 sur une face du substrat et une couche N 10 sur l'autre face. Bien entendu, les précautions habituelles à l'homme de l'art sont prises pour que la seconde épitaxie ne détériore pas la couche réalisée au cours de la première épitaxie. Le procédé utilisé pour les épitaxies n'intervient pas dans le résultat: elle peuvent être à pression atmosphérique ou sous basse pression.

Ce qui fait l'originalité de la diode selon l'invention est que les niveaux de dopage, au cours des épitaxies, sont de 10 à 100 fois moindres que les niveaux de dopage habituels: ils sont au niveau de $5.10^{16}$ à $5.10^{18}$ at.cm$^{-3}$, alors que l'on connait des diodes épitaxiées mais à des niveaux supérieurs à $10^{19}$ at.cm$^{-3}$, ce qui introduit des contraintes mécaniques entre couches très dopées et zone I, et donc diminue la durée de vie $\tau$, comme cela a été dit.

Il est utile de terminer chaque opération d'épitaxie par un court surdopage à $10^{19}$ at.cm$^{-3}$, afin de créer de fines couches de 1 ou 2 micromètres, 11 du côté P et 12 du côté N, destinées à améliorer le contact ohmique pris sur ces couches. Cette opération est bien connue, et ce léger surdopage n'interfère pas avec l'invention, puisqu'il concerne les prises de contact et non pas les transitions P–I et I–N. Ce mince surdopage peut aussi être réalisé par diffusion courte.

La partie supérieure de la figure 5 met en évidence les transitions abruptes: le substrat 8, qui constitue maintenant la zone I, de longueur bien définie W, est non dopé, à un niveau de $2.10^{12}$ par exemple, représenté par la droite 13. Le niveau de dopage des couches P 9 et N 10 est représenté par les droites horizontales 14 et 15, aux environs de $5.10^{16}$–$5.10^{18}$. Etant donné que le taux de dopage a été maintenu constant pendant toute la durée des épitaxies – sauf le surdopage final pour les contacts – et qu'il n'y a pas diffusion d'impuretés dans le substrat, ou zone I, les transitions P–I et I–N sont abruptes et représentées respectivement par les droites 16 et 17, quasi verticales sur ce graphique.

A titre d'exemple non limitatif, considérons une diode PIN pour laquelle:

$W = 100 \ \mu m$

$S = 500 \times 500 \ \mu m$

$I_D = 100 \ mA$

$\rho_0 = 4000 \ \Omega/cm$

$R_D = 0,5 \ \Omega$

Si on désire que les résistances "parasites" $R_P$ et $R_N$ soient au maximum égales au dixième de la résistance en direct $R_D$

$$R_P + R_N = \frac{1}{10}R_D$$

et en admettant $R_P = R_N = 0,025 \ \Omega$ et que les couches épitaxiées ont même épaisseur, $10\mu$ par exemple, on trouve

$C_N = 2.10^{17}$ at.cm$^{-3}$

$C_P = 10^{18}$ at.cm$^{-3}$

soit une résistivité de $0,06 \ \Omega/cm$ pour chaque couche épitaxiée. Sur la figure 5, le niveau de dopage de la couche P 9 est effectivement voisin de $10^{18}$, tandis que le niveau de la couche N 10 est un peu supérieur à $10^{17}$.

La diode PIN selon l'invention a beaucoup moins de contraintes mécaniques que les diodes selon l'art connu, puisque les couches P et N sont moins dopées: par conséquent, la durée de vie $\tau$ des porteurs de charges est plus élevée, ce qui diminue la résistance en direct $R_D$.

Enfin, ce qui n'est pas négligeable du point de vue du rendement de fabrication industrielle, la découpe des diodes dans la tranche de silicium est de meilleur rendement, puisqu'il y a moins de contraintes mécaniques entre les couches de la diode PIN.

La diode PIN selon l'invention est d'usage général, mais elle est surtout utilisée en hyperfréquences.

## Revendications

1. Diode hyperfréquence de type PIN, comprenant, supportées par un substrat en silicium non intentionnellement dopé ($\simeq 10^{12}$ at.cm$^{-3}$) qui constitue la zone I (8), une première couche (9) d'un premier type de conductivité (P) sur une première face du substrat (8), et une deuxième couche (10) d'un second type de conductivité (N) sur une seconde face de substrat (8), cette diode étant caractérisée en ce que lesdites couches (9, 10) sont des couches épitaxiées sur le substrat (8), le niveau de dopage par des impuretés de ces couches (9, 10) étant constant sur toute l'épaisseur de la couche, et compris entre $5 \cdot 10^{16}$ et $5 \cdot 10^{18}$ at.cm$^{-3}$, et en ce que la transition P–I entre couche P (9) et zone I (8), et la transition I–N entre couche N (10) et zone I (8), sont des transitions abruptes.

2. Diode PIN selon la revendication 1, caractérisée en ce que chacune des deux couches P et N (9, 10) comporte en outre une fine couche (11, 12 respectivement) dopée à un taux normal de $10^{19}$ at.cm$^{-3}$, en vue d'assurer une bonne ohmicité de la prise de contact sur lesdites couches (9, 10).

## Patentansprüche

1. Höchstfrequenzdiode vom PIN-Typ, mit einer ersten Schicht (9) eines ersten Leitfähigkeitstyps (P) auf der ersten Fläche eines Substrats (8) sowie mit einer zweiten Schicht (10) eines zweiten Leitfähigkeitstyps (N) auf einer zweiten Fläche des Substrats (8), das durch ein unbeabsichtigt dotiertes ($\simeq 10^{12}$ at.cm$^{-3}$) Silizium-Substrat gebildet ist, welches die Zone I (8) bildet, wobei diese Diode dadurch gekennzeichnet ist, daß diese Schichten (9, 10) auf dem Substrat (8) epitaktisch aufgebrachte Schichten sind, wobei die Stärke der durch Verunreinigungen dieser Schichten (9, 10) erzeugten Dotierung über die gesamte Dicke der Schicht konstant ist und zwischen $5 \cdot 10^{16}$ und $5 \cdot 10^{18}$ at.cm$^{-3}$ beträgt, und daß der Übergang P–I zwischen der Schicht P (9) und der Zone I (8) sowie der Übergang I–N zwischen der Schicht N (10) und der Zone I (8) abrupte Übergänge sind.

2. PIN-Diode nach Anspruch 1, dadurch gekennzeichnet, daß jede der beiden Schichten P und N (9, 10) ferner eine dünne Schicht (11 bzw. 12) umfaßt, welche mit einer normalen Stärke von $10^{19}$ at.cm$^{-3}$ dotiert ist, damit ein guter Ohmscher Kontakt auf diesen Schichten gewährleistet ist.

## Claims

1. A VHF diode of the PIN type, comprising, supported on a silicon substrate which is not intentionally doped ($\simeq 10^{12}$ at.cm$^{-3}$) and which constitutes the I zone (8), a first layer (9) of a first type of conductivity (P), and a second layer (10) of a second type of conductivity (N) on a second face of the substrate (8), said diode being characterized in that the said layers (9 and 10) are epitaxially formed on the substrate (8), the doping level by impurities in the layers (9 and 10) being constant for the entire thickness of the layer, and comprised between $5 \cdot 10^{16}$ and $5 \cdot 10^{18}$ at.cm$^{-3}$, and in that the P-I transition between the P layer (9) and the I zone (8) and the I–N transition between the N layer (10) and the I zone (8) are abrupt transitions.

2. The PIN diode as claimed in claim 1, characterized in that each of the two P and N layers (9 and 10) furthermore comprises a thin layer (11 and, respectively, 12) doped at a normal level of $10^{19}$ at.cm$^{-3}$ with the purpose of ensuring good ohmic properties of the contact means on the said layers (9 and 10).

Fig.1

Fig.2

Fig.3

Fig.4

Fig.5